# EUROPEAN PATENT APPLICATION

(11) **EP 2 610 897 A1**
(43) Date of publication of application: **03.07.2013**
(21) Application number: 11819681.5
(22) Date of filing: 30.06.2011
(51) Int. Cl.: H01L 21/3065, C04B 41/87, C04B 41/91, H01L 21/683

(54) **PLASMA-RESISTANT MEMBER AND METHOD FOR REGENERATING SAME**

(30) Priority: 25.08.2010 JP 2010188056
(71) Applicant: Mitsui Engineering & Shipbuilding Co., Ltd., Chuo-ku Tokyo 104-8439 (JP); Admap, Inc., Tamano-shi, Okayama 706-0014 (JP)
(72) Inventor: KAWAMOTO Satoshi, Tamano-shi Okayama 706-0014 (JP); NAKAMURA Masaki, Tamano-shi Okayama 706-0014 (JP); TAKAHARA Hideyuki, Tamano-shi Okayama 706-0014 (JP); WU Robert, Tamano-shi Okayama 706-0014 (JP)
(74) Representative: Grünecker, Kinkeldey, Stockmair & Schwanhäusser
(86) International application number: PCT/JP2011/065080
(87) International publication number: WO 2012/026210

(57) **Abstract**

Provided is a plasma-resistant member which can be recycled and does not easily produce particles even when exposed to plasma. Specifically provided is a plasma-resistant member which has a predetermined surface profile and is used within a plasma etching chamber. The plasma-resistant member comprises: a first SiC layer (12) that is formed by a CVD method and has a corroded surface by having been exposed to plasma etching; and a second SiC layer (13) that is laminated on the corroded surface of the first SiC layer (12) by a CVD method and has a surface that is machined so as to have the predetermined surface profile.

## Description

### TECHNICAL FIELD

The present invention relates to plasma-resistant members for use in a plasma etching chamber, particularly to such members as focus rings, shower heads and electrostatic chucks used in a semiconductor device production process to conduct plasma etching treatment on a substrate and the like.
The present invention is also directed to methods of regenerating such plasma-resistant members.

### BACKGROUND ART

Semiconductor device production processes use a plasma etching system for conducting plasma etching treatment on a substrate by introducing a specified gas into a chamber and applying a high frequency voltage between a lower electrode also serving as a substrate mount and an upper electrode opposite to the lower electrode so as to generate the plasma with which the treatment is carried out.
In such a plasma etching system, a focus ring is fitted on the periphery of an electrostatic chuck in order to protect the electrostatic chuck holding a substrate from erosion by plasma. A material often used for focus rings is monocrystalline Si, which is generally high in purity, controllable in electric resistance, and of low cost.
Monocrystalline Si, however, is liable to be eroded by plasma and, accordingly, generate particles, involving a problem of short lifetime.

Patent Literature 1, for instance, has proposed as a countermeasure to form a CVD-SiC (chemical vapor deposited silicon carbide) film on the surface portion to be exposed to plasma. In comparison with Si (silicon), CVD-SiC is hard to erode and thus hardly generates particles, with its lifetime being 1.8 to 2.3 times longer.

### CITATION LIST

### PATENT LITERATURE

Patent literature 1: JP 2006-128372 A

### SUMMARY OF INVENTION

### TECHNICAL PROBLEMS

Unfortunately, CVD-SiC is two to four times as expensive as Si. In addition, used focus rings need to be disposed of as industrial wastes.

The present invention, as aiming at solving the above problems with the prior art, has an object of providing a plasma-resistant member which hardly generates particles when exposed to plasma and is, moreover, recyclable.
It is another object of the present invention to provide a method of regenerating such a plasma-resistant member.

### SOLUTION TO PROBLEMS

In order to achieve the objects as above, the plasma-resistant member according to the present invention is a plasma-resistant member with a specified surface profile adapted for use in a plasma etching chamber, comprising: a first SiC layer formed by chemical vapor deposition and having an eroded surface resulting from exposure to plasma etching treatment; and a second SiC layer deposited by chemical vapor deposition on the eroded surface of the first SiC layer and having a surface so machined as to be provided with the specified surface profile.
The plasma-resistant member is a shower head, a focus ring or an electrostatic chuck.

The method of regenerating a plasma-resistant member according to the present invention is a method of regenerating a plasma-resistant member with a specified surface profile adapted for use in a plasma etching chamber, with the plasma-resistant member having in at least a surface portion thereof a first SiC layer formed by chemical vapor deposition, the method comprising: newly depositing a second SiC layer by chemical vapor deposition on an eroded surface of the first SiC layer of the plasma-resistant member which has been used, the eroded surface resulting from exposure to plasma etching treatment; and machining a surface of the second SiC layer as deposited, so as to provide the surface with the specified surface profile.

### ADVANTAGEOUS EFFECTS OF INVENTION

According to the present invention, the plasma-resistant member which hardly generates particles when exposed to plasma and is, moreover, recyclable is provided.

### BRIEF DESCRIPTION OF DRAWINGS

[Fig. 1] Fig. 1 is a sectional view illustrating the configuration of a plasma treatment apparatus.
[Fig. 2] Fig. 2 is a sectional view of a focus ring eroded due to plasma etching treatment.
[Fig. 3] Fig. 3 comprises sectional views for an explanation of how to restore a used focus ring.

### DESCRIPTION OF EMBODIMENTS

The present invention is detailed below on the basis of the preferred embodiment as shown in the accompanying drawings.

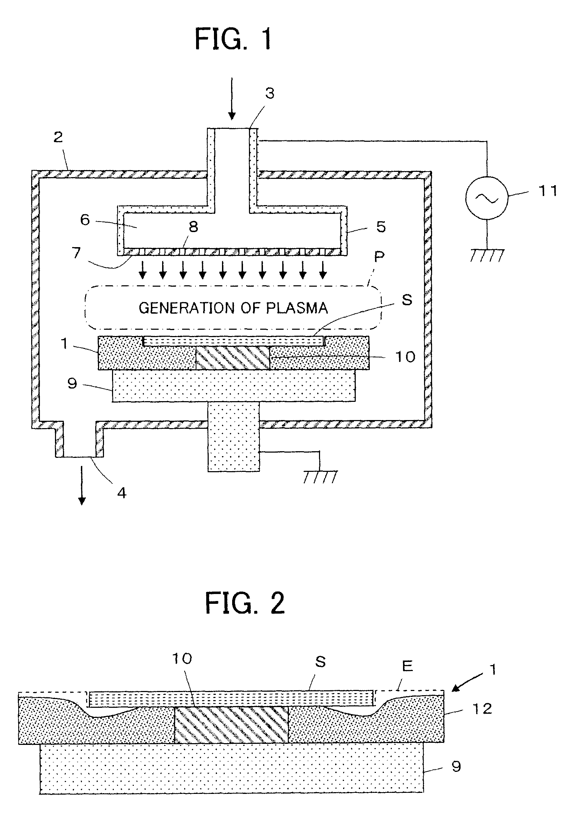

Fig. 1 shows the configuration of a plasma treatment apparatus provided with a focus ring 1. The plasma treatment apparatus includes a plasma etching chamber 2 with its inside being kept gas-tight to the outside.

In the top of the plasma etching chamber 2, a gas inlet 3 for feeding a reactive gas into the chamber is provided, while a gas outlet 4 for exhausting the reactive gas from the chamber is provided in the bottom of the plasma etching chamber 2. The gas inlet 3 is connected with a gas source not shown, from which a reactive gas for plasma generation is fed into the plasma etching chamber 2 through the gas inlet 3. The gas outlet 4 is connected to a decompressor not shown, which allows a specified degree of vacuum in the plasma etching chamber 2 and makes adjustments so that a specified degree of vacuum may be maintained in the plasma etching chamber 2 as fed with the reactive gas. A vacuum pump or a cryocoil may be used as the decompressor.

The gas inlet 3 is connected to a shower head holder 5. A hollow space in the shower head holder 5 constitutes a gas feeding space 6, into which the reactive gas is fed through the gas inlet 3. The shower head holder 5 and the plasma etching chamber 2 are electrically insulated from each other.
On the bottom side of the shower head holder 5, a shower head 7 is attached as if it closes the gas feeding space 6 from below. The shower head 7 has a plurality of nozzles 8 formed therethrough from the top to the bottom face. The reactive gas fed from the gas feeding space 6 is expelled downward from the shower head 7 through the nozzles 8. The shower head 7 includes an upper electrode formed of a conductive material, with a plasma-generating space P being produced under the shower head 7.

In a lower portion of the inside of the plasma etching chamber 2, a lower electrode 9 and an electrostatic chuck 10 are provided opposite to the shower head 7, with the plasma-generating space P being located between them. The lower electrode 9 is positioned parallel with the upper electrode of the shower head 7 and grounded. The lower electrode 9 and the upper electrode of the shower head 7 are used in a pair to generate plasma. The electrostatic chuck 10 is placed on the lower electrode 9, so that a voltage from a high-voltage DC power source not shown, as being applied to the lower electrode, generates an electrostatic force between the lower electrode and a substrate S mounted on the top face of the electrostatic chuck 10, which secures the substrate S to the electrostatic chuck 10. The electrostatic chuck 10 and the plasma etching chamber 2 are electrically insulated from each other.

The upper electrode of the shower head 7 is connected with a high-frequency power source 11 via the shower head holder 5. The high-frequency power source 11 is adapted to feed electric power for plasma generation, and any known high-frequency power source for use in plasma treatment apparatus is available for the power source 11.

The focus ring 1 is an annular member with a circular recess, into which the substrate S is to be fitted, the annular member being fitted on the periphery of the electrostatic chuck 10 so that the electrostatic chuck 10 on which the substrate S is to be mounted may not be exposed directly to plasma. As shown in Fig. 1, the recess of the focus ring 1 is formed such that, when the substrate S has been fitted into the recess, the surfaces of the focus ring 1 and of the substrate S that are exposed to plasma are in the same plane.
The focus ring 1 is not particularly limited in material as long as it has a SiC layer formed by chemical vapor deposition (CVD) at least at its surface.

Fig. 2 is a sectional view of the focus ring 1 as eroded due to plasma etching treatment. In the drawing, a specified shape of the focus ring 1 before use is depicted with a broken line.
When plasma etching treatment is repeatedly conducted on the substrate S over a long period of time, a SiC layer 12 constituting the focus ring 1 is eroded starting from a part directly exposed to plasma, so that a deep groove, namely, eroded portion E shown in Fig. 2 occurs gradually.
If the eroded portion E occurs, the plasma etching treatment on the substrate S will be hindered because the surface of the substrate S and the surface of the SiC layer 12 that is exposed to plasma are no longer in the same plane and the plasma-generating field P varies. The focus ring 1 as above is not able to be used further but needs to be replaced by a new focus ring with the specified shape.

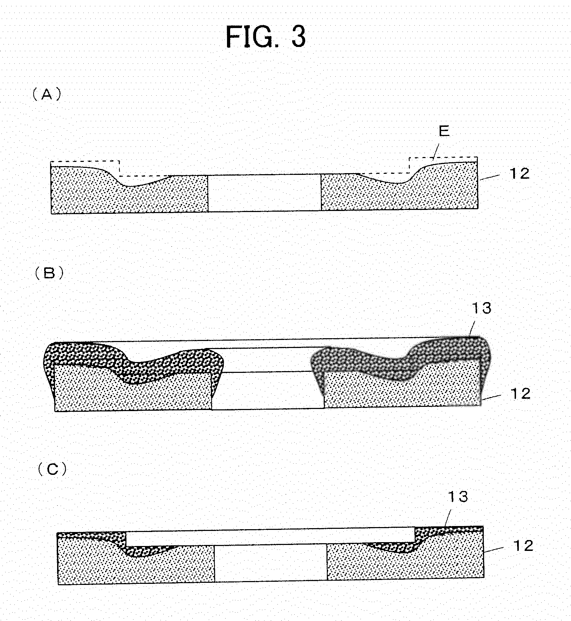

Referring to Fig. 3, the method of restoring a plasma-resistant member according to the present invention is described.
A focus ring 1 shown in Fig. 3(A) is the used focus ring which was exposed to plasma etching treatment and includes a first SiC layer 12 formed by CVD and partially eroded. In the drawing, an eroded portion is denoted by the character E, and a specified shape of the focus ring 1 before use is shown with a broken line.

As shown in Fig. 3(B), a new, or second SiC layer 13 is initially deposited by CVD on the eroded surface of the first SiC layer 12 as exposed to plasma etching treatment and eroded at its surface, accordingly. The second SiC layer 13 to be deposited is not particularly limited in thickness as long as the eroded portion E is covered with it.
Preferably, impurities attached onto the surface of the used focus ring 1 are washed out before the deposition of the second SiC layer 13.

The deposited second SiC layer 13 is then machined at its surface so that the surface may attain the profile before use, as shown in Fig. 3(C). The machining method is not particularly limited as long as the specified shape is yielded by machining, with exemplary methods including mechanical polishing using diamond particles as abrasive grain.

The restoration of a used focus ring by the plasma-resistant member restoring method of this embodiment makes it possible to obtain a recyclable focus ring including the first SiC layer 12 formed by CVD and having an eroded surface resulting from exposure to plasma etching treatment, and the second SiC layer 13 deposited by CVD on the eroded surface of the first SiC layer 12 and having a surface so machined as to be provided with a specified surface profile.

The plasma-resistant member regenerating method of this embodiment is less expensive than the fabrication of a new focus ring, so that the reduction in total cost by recycling is made significant by two- to four-time recycling of a focus ring newly fabricated.
While no particular limitation is made to the depth of the eroded portion E of the used focus ring 1, a depth of 1 to 1.5 mm is preferred. A focus ring with such a depth of eroded portion can be restored at a cost lower than the cost of fabricating a new focus ring 1.

The plasma-resistant member as employed in the embodiment as above is a focus ring, to which the present invention is not limited. Any plasma-resistant member having a specified shape and adapted for the use in a plasma etching chamber, an electrostatic chuck or a shower head, for instance, may also be employed.

### REFERENCE SIGNS LIST

1 focus ring; 2 plasma etching chamber; 3 gas inlet; 4 gas outlet; 5 shower head holder; 6 gas feeding space; 7 shower head; 8 nozzle; 9 lower electrode; 10 electrostatic chuck; 11 high-frequency power source; 12 SiC layer (first SiC layer); 13 second SiC layer; E eroded portion; S substrate.

## Claims

1. A plasma-resistant member with a specified surface profile adapted for use in a plasma etching chamber, comprising:
a first SiC layer formed by chemical vapor deposition and having an eroded surface resulting from exposure to plasma etching treatment; and
a second SiC layer deposited by chemical vapor deposition on the eroded surface of the first SiC layer and having a surface so machined as to be provided with the specified surface profile.

2. The plasma-resistant member according to claim 1, which is a shower head, a focus ring, or an electrostatic chuck.

3. A method of regenerating a plasma-resistant member with a specified surface profile adapted for use in a plasma etching chamber, with the plasma-resistant member having in at least a surface portion thereof a first SiC layer formed by chemical vapor deposition, the method comprising:
newly depositing a second SiC layer by chemical vapor deposition on an eroded surface of the first SiC layer of the plasma-resistant member which has been used, the eroded surface resulting from exposure to plasma etching treatment; and
machining a surface of the second SiC layer as deposited, so as to provide the surface with the specified surface profile.

4. The method of regenerating a plasma-resistant member according to claim 3, wherein said plasma-resistant member is a shower head, a focus ring, or an electrostatic chuck.
